(19) Europäisches Patentamt
European Patent Office
Office européen des brevets

(11) Publication number: 0 382 209 A2

# (12) EUROPEAN PATENT APPLICATION

(21) Application number: 90102484.4

(51) Int. Cl.5: G03F 7/029

(22) Date of filing: 08.02.90

(30) Priority: 10.02.89 JP 31841/89

(43) Date of publication of application: 16.08.90 Bulletin 90/33

(84) Designated Contracting States: CH DE FR GB LI

(71) Applicant: NIPPON PAINT CO., LTD.
2-1-2, Oyodokita Kita-ku
Osaka-shi Osaka-fu(JP)

(72) Inventor: Harada, Masahiko
4-25-1, Kishibekita
Suita-shi, Osaka(JP)

(74) Representative: Hansen, Bernd, Dr.rer.nat. et al
Hoffmann, Eitle & Partner Patentanwälte
Arabellastrasse 4 Postfach 81 04 20
D-8000 München 81(DE)

## (54) Photocurable composition.

(57) The present invention provides a photocurable composition which is rapidly cured. The composition comprises a polymerizable compound having an ethylenically unsaturated double bond and a photopolymerization initiator wherein the photopolymerization initiator comprises;

(a) a compound having the following formula [I];

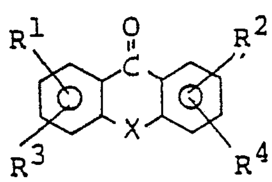

[I]

[wherein X represents a sulfur atom or -CO-, $R^1$, $R^2$, $R^3$ and $R^4$ respectively represent a hydrogen atom, an alkyl group, a substituted alkyl group, an aryl group, an alkoxy group, $-CH_2COOH$, a nitro group, a sulfonyl group, a phosphonyl group, a cyano group, a hydroxyl group and a halogen atom.], or an alpha-diketone compound having the formula [II];

$$R^5-\overset{O}{\overset{\|}{C}}-\overset{O}{\overset{\|}{C}}-R^6 \quad [II]$$

[wherein $R^5$ and $R^6$ respectively represent an alkyl group, an alkoxy group or an aryl group, provided that neither $R^5$ nor $R^6$ is an alkoxy group.]

(b) carbon tetrachloride or a compound having tribromomethylsulfonyl, and

(c) an amine having carbon atoms directly bonded to a nitrogen atom, at least one of which is methylene group.

EP 0 382 209 A2

# PHOTOCURABLE COMPOSITION

## FIELD OF THE INVENTION

The present invention relates to a photocurable composition which is rapidly cured with lights having various wavelength, such as ultraviolet light, visible light and the like.

## BACKGROUND OF THE INVENTION

Photocurable compositions which are cured by exposing to light are widely applied for photoresist, a photomolding material, ink, printing plates and the like. The photocurable compositions contain a photopolymerization initiator generating free radicals by exposure to light and a radical polymerizable monomer as main components.

In order to enhance the photosensitivity of the photocurable composition, much effort has been paid on improvement of the photopolymerization initiator, and ketals, benzoine ethers or acetophenones have been proposed for the initiator.

The proposed initiators are sufficient properties, but it is still desired to more rapidly cure the composition. The rapid cure makes it possible to save output of light source and to shorten operating time.

## SUMMARY OF THE INVENTION

The present invention provides a photocurable composition which is rapidly cured. The photocurable composition of the present invention comprises a polymerizable compound having an ethylenically unsaturated double bond and a photopolymerization initiator wherein the photopolymerization initiator comprises;

(a) a compound having the following formula [I];

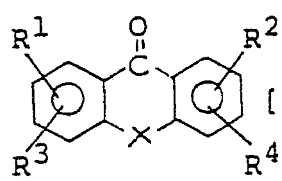

[I]

[wherein X represents a sulfur atom or -CO-, $R^1$, $R^2$, $R^3$ and $R^4$ respectively represent a hydrogen atom, an alkyl group, a substituted alkyl group, an aryl group, an alkoxy group, $-CH_2COOH$, a nitro group, a sulfonyl group, a phosphonyl group, a cyano group, a hydroxyl group and a halogen atom.], or an alpha-diketone compound having the formula [II];

$$R^5-\overset{\overset{O}{\|}}{C}-\overset{\overset{O}{\|}}{C}-R^6 \qquad [II]$$

[wherein $R^5$ and $R^6$ respectively represent an alkyl group, an alkoxy group or an aryl group, provided that neither $R^5$ nor $R^6$ is an alkoxy group.]

(b) carbon tetrabromide or a compound having a tribromomethylsulfonyl group, and

(c) an amine having carbon atoms directly bonded to a nitrogen atom, at least one of which is methylene group.

## DETAILED DESCRIPTION OF THE INVENTION

In the compound [I], $R^1$, $R^2$, $R^3$ and $R^4$ respectively represent a hydrogen atom, an alkyl group, a substituted alkyl group, an aryl group, an alkoxy group, $-CH_2COOH$, a nitro group, a sulfonyl group, a phosphenyl group, a cyano group, a hydroxyl group and a halogen group. The alkyl group preferably contains 1 to 4 carbon atoms, for example methyl, ethyl, propyl, butyl and the like. The substituent of the substituted alkyl group includes an alkoxy group having 1 to 3 carbon atoms (such as methoxy, ethoxy and propoxy), a phenyl group, a halogen atom (such as chlorine and bromine) or an amino group. The alkoxy group and halogen atom of $R^1$, $R^2$, $R^3$ and $R^4$ are the same as listed in the substituent of the substituted

alkyl group. Typical examples of the compound [I] are anthraquinone, 2-methylanthraquinone, 2-ethylanthraquinone, 2-isopropylanthraquinone, 2-chloroanthraquinone, 1-sulfonylchloroanthraquinone, 2,4-dimethylthioxanthone, 2,4-diethylthioxanthone, 2-chlorothioxanthone and the like.

In the compound [II], $R^5$ and $R^6$ respectively are an alkyl group, an alkoxy group or an aryl group. The alkyl group preferably contains 1 to 4 carbon atoms and the alkoxy group contains 1 to 3 carbon atoms. The substituent of the aryl group is an alkyl group having 1 to 4 carbon atoms, an alkoxy group having 1 to 3 carbon atoms, a halogen atom or a nitro group. Neither $R^5$ nor $R^6$ is an alkoxy group. When both $R^5$ and $R^6$ are an alkoxy group, the compound [II] is a diester which do not have polymerization initiating function. Typical examples of the compound [II] are benzil, 4,4-dimethoxybenzil, 1-phenyl-1,2-propanedione, methylbenzoyl formate, 2,3-butanedione and the like.

The component (b) of the present invention is carbon tetrabromide and a compound having a tribromomethylsulfonyl group. Examples of the compounds having tribromomethylsulfonyl group are tribromomethylphenylsulfone, 2-tribromomethylsulfonyl pyridine, 2-tribromomethylsulfonyl benzothiazole and the like.

The amine having a carbon atom directly bonded to a nitrogen atom, at least one of which is a methylene group (compound c) includes triethylamine, N-methyldiethanolamine, triethanolamine, diethanolamine, benzyldimethylamine and the like. Preferred is N-methyldiethanolamine.

The polymerizable compound having an ethylenically unsaturated double bond (polymerizable compound) of the present invention is usually a monomer or polymer having an ethylenically unsaturated bond, by which an addition polymerization occurs to cause curing. Typical examples of the polymerizable compounds are an unsaturated carboxylic acid, an ester of unsaturated carboxylic acids and polyhydroxy compounds, an addition product of unsaturated carboxylic acids and epoxides, a (meth)acrylamide and the like. The polyhydroxy compounds include aliphatic or aromatic polyhydroxy compounds, and a mixture thereof. A polycarboxylic acid which does not have an unsaturated bond can be mixed with the unsaturated carboxylic acid. Examples of unsaturated carboxylic acids are acrylic acid, methacrylic acid and the like. Examples of aliphatic polyhydroxy compounds are diols, such as ethylene glycol, diethylene glycol, triethylene glycol, tetraethylene glycol, neopentyl glycol, propylene glycol, 1,2-butanediol and the like; triols, such as trimethylolethane, trimethylolpropane, glycerol and the like; higher polyols, such as pentaerythritol, tripentaerythritol and the like; and polyhydroxycarboxylic acids. Examples of aromatic polyhydroxy compounds are hydroquinone, resolcine, catechol, pyrogallol and the like. Epoxides include trimethylolpropane polyglycidyl ether, pentaerythritol polyglycidyl ether, propylene glycol diglycidyl ether, diglycidyl ester of phthalic acid, a reaction product of epichlorohydrin with 2,2-bis(4-hydroxyphenyl)-propane and the like. Examples of (meth)acrylamides are acrylamide, ethylene bisacrylamide, ethylene bismethacrylamide, hexamethylene bisacrylamide and hexamethylene bismethacrylamide. Preferred is an acrylate or methacrylate.

The component (a) employed in the present invention is present in the composition in an amount of 0.01 to 0.3 mol, preferably 0.025 to 0.2 mol based on one liter of the polymerizable compound. An amount of the component (b) is within the range of 0.01 to 0.2 mol, preferably 0.02 to 0.1 mol based on one liter of the polymerizable compound. The component (c) is present in an amount of 0.005 to 0.5 mol, preferably 0.01 to 0.25 mol based on one liter of the polymerizable compound. Amounts less than the lower limit of each component reduce curing speed and it takes a long period of time to cure. Amounts more than the upper limit of each component result in a cured film having low film strength or low solvent resistance.

The photocurable composition of the present invention may contain polymer components and polymerization inhibitors, if desired. Typical examples of the polymer components are a partially esterified vinyl acetate cellulose derivative, polyethylene oxide, poly(sodium acrylate), polyamide and the like. The polymer components can also be poly(alkyl acrylate); a copolymer of alkyl acrylate with acrylic acid, methacrylic acid, acrylonitrile, butadiene, styrene and the like; poly(alkyl methacrylate); a copolymer of alkyl methacrylate with acrylic acid, methacrylic acid, acrylonitrile, butadiene, styrene and the like. The polymer component may be present in the composition in an amount of not more than 1,000 parts by weight, preferably not more than 200 parts by weight based on 100 part by weight of the polymerizable compound.

The polymerization inhibitor includes 2,6-di-t-butyl-p-cresol, hydroquinone and p-methoxyphenol and the like. These inhibitors are present in an amount of 0 to 5 parts by weight, preferably 0 to 2 based on 100 parts by weight of the polymerizable compound.

The photocurable composition may be prepared by mixing the above mentioned components and if necessary water or an organic solvent with a kneader or mixer in a cool and dark place. Suitable solvents are ketones, such as methyl ethyl ketone, acetone and cyclohexanone; esters, such as ethyl acetate, butyl acetate and ethyl propionate; aromatic hydrocarbons, such as toluene and xylene; ethylene glycol monoalkyl ether, such as ethylene glycol monomethyl ether, ethylene glycol monoethyl ether and ethylene glycol monobutyl ether; alcohols, such as methanol, ethanol and propanol; ethers, such as tetrahydrofuran and

dioxane; and the like.

The photocurable composition can be used intact or formed to any shape. The composition is suitable for UV curing ink, UV curing paint, printing plates, dry-film resist, microlithography resist and the like.

Light sources for the photocurable composition of the present invention are high-pressure mercury lamps, middle pressure mercury lamps, xenon lamps, metal halide lamps and the like.

The composition of the present invention is very sensitive to light, especially ultraviolet, and cures very fast. The composition saves output of a light source and reduces operation time.

## Examples

The present invention is illustrated by the following examples, but they are not construed as limiting the present invention.

### Examples 1 to 7 and Comparative Examples 1 to 6

#### Preparation of photopolymerizable composition

Components a, b and c in Table 1 were dissolved in one liter of 2-hydroxyethyl methacrylate in an amount as shown in Table 1 to obtain a photocurable composition solution. Photosensitivity, curing speed of the solution were evaluated as follow and the results are shown in Table 1.

The solution (3 g) was put into a cylindrical aluminum can having a diameter of 5.5 cm and a depth of 7 mm, and exposed to a ultra-high pressure mercury lamp (3 KW) available from Oak Production Company vertically apart at a distance of 60 cm. Exposure was continued until, when a metal needle having 30 g and a tip diameter of 0.5 mm was vertically dropped at a distance of 1 cm, the tip was not stuck in the cured composition. Photosensitivity was based on the period of time from the beginning of the exposure to the end time when the tip of the needle was not stuck.

For comparison, some compositions in which one of the components was not formulated were prepared and the same test was conducted. Also, photocurable compositions which contained a commercially available polymerization initiator (i.e. banzyldimethyl ketal available from Chiba Geigy A.G. as Iregacure 651; or 1-hydroxy-1-cyclohexyl acetophenone available from Chiba Geigy A.G. as Iregacure 184) were prepared and the same test was conducted. The results also are shown in Table 1.

Table 1

| Examples No. | Component (a) (mol/l) | Component (b) (mol/l) | Component (c) (mol/l) | Curing speed (Irradiation time in second) |
|---|---|---|---|---|
| 1 | a-1 0.05 | b-1 0.05 | 0.25 | 50 |
| 2 | a-2 0.05 | b-1 0.05 | 0.25 | 50 |
| 3 | a-3 0.05 | b-1 0.05 | 0.25 | 50 |
| 4 | a-3 0.1 | b-1 0.1 | 0.05 | 40 |
| 5 | a-4 0.2 | b-1 0.1 | 0.1 | 37 |
| 6 | a-6 0.2 | b-1 0.05 | 0.05 | 45 |
| 7 | a-3 0.05 | b-2 0.05 | 0.05 | 40 |
| Comparative ex. 1 | a-3 0.05 | - | 0.25 | 300 |
| 2 | a-4 0.05 | - | 0.25 | 300 |
| 3 | a-4 0.05 | b-1 0.05 | - | 530 |
| 4 | - | b-1 0.05 | 0.25 | 220 |
| 5 | Benzyldimethyl ketal 0.05 | | | 65 |
| 6 | 1-Hydroxy-1-cyclohexyl acetophenone 0.05 | | | 85 |

a-1 2-Ethylanthraquinone
a-2 2,4′-Diethylthioxanthone
a-3 Benzil
a-4 1-Phenyl-1,2-propanedione
a-5 Methylbenzoyl formate
a-6 2,3-Butanedione
b-1 Carbon tetrabromide
b-2 Tribromomethylphenylsulfone
c N-Methyldiethanolamine

## Examples 8 to 12 and comparative Examples 7 to 12

### Preparation of photopolymerizable composition

Components a, b and c in Table 1 were dissolved in one liter of 2-hydroxypropyl methacrylate and 250 ml of methyl ethyl ketone in an amount as shown in Table 2 to obtain a photocurable composition solution. Photosensitivity, curing speed of the solution were evaluated as follow and the results are shown in Table 2.

The solution (8 g) was put into a hard glass container having a diameter of 23 cm, and exposed to a high pressure mercury lamp (400 W) available from Toshiba Co., Ltd. horizontally apart at a distance of 18 cm. During exposing, a viscosity of the photocurable solution was measured and continued until it reached 500 ps. The time from the start point to 500 ps was expressed as curing speed.

For comparison, some compositions in which one of the components was not formulated were prepared and the same test was conducted. Also, photocurable compositions which contained a commercially available polymerization initiator (i.e. banzyldimethyl ketal available from Chiba Geigy A.G. as Iregacure 651; and 1-hydroxy-1-cyclohexyl acetophenone available from Chiba Geigy A.G. as Iregacure 184) were prepared and the same test was conducted. The results also are shown in Table 2.

Table 2

| Examples No. | Component (a) (mol/l) | Component (b) (mol/l) | Component (c) (mol/l) | Curing speed (Irradiation time in second) |
|---|---|---|---|---|
| 8 | a-1 0.005 | b-1 0.025 | 0.125 | 712 |
| 9 | a-3 0.025 | b-1 0.025 | 0.125 | 602 |
| 10 | a-4 0.1 | b-1 0.05 | 0.05 | 710 |
| 11 | a-5 0.025 | b-1 0.025 | 0.125 | 645 |
| 12 | a-3 0.025 | b-2 0.025 | 0.125 | 605 |
| Comparative ex. 7 | a-3 0.025 | - | 0.125 | 2110 |
| 8 | a-4 0.025 | - | 0.125 | 2338 |
| 9 | - | b-1 0.025 | - | 4040 |
| 10 | - | b-1 0.025 | 0.125 | 1980 |
| 11 | Benzyldimethyl ketal 0.025 | | | 825 |
| 12 | 1-Hydroxy-1-cyclohexyl acetophenone 0.025 | | | 948 |

As is apparent from Comparative Examples 1 to 4 and 7 to 10, if the composition does not contain only one component, the curing speed remarkably reduces. Also, the photocurable composition of the present invention has faster curing speed than the compositions of Comparative Examples 5, 6, 11 and 12 which contained conventional photopolymerization initiator. The composition of the present invention is applicable to wide variety of usages.

## Claims

1. A photocurable composition comprising a polymerizable compound having an ethylenically unsaturated double bond and a photopolymerization initiator wherein the photopolymerization initiator comprises;

(a) a compound having the following formula [I];

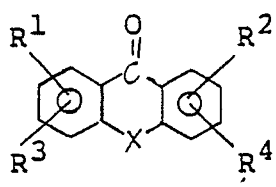

[I]

[wherein X represents a sulfur atom or -CO-, $R^1$, $R^2$, $R^3$ and $R^4$ respectively represent a hydrogen atom, an alkyl group, a substituted alkyl group, an aryl group, an alkoxy group, $-CH_2COOH$, a nitro group, a sulfonyl group, a phosphonyl group, a cyano group, a hydroxyl group and a halogen atom.], or an alpha-diketone compound having the formula [II];

$$R^5-\overset{\overset{O}{\|}}{C}-\overset{\overset{O}{\|}}{C}-R^6 \quad [II]$$

[wherein $R^5$ and $R^6$ respectively represent an alkyl group, an alkoxy group or an aryl group, provided that neither $R^5$ nor $R^6$ is an alkoxy group.]

(b) carbon bromide or a compound having tribromomethylsulfonyl, and

(c) an amine having carbon atoms directly bonded to a nitrogen atom, at least one of which is methylene group.

2. The composition according to Claim 1 wherein said component (a) is present in an amount of 0.001 to 0.3 mol, said component (b) is present in an amount of 0.01 to 0.2 mol, and said component (c) is present in an amount of 0.005 to 0.5 mol, the amounts being based on one liter of the polymerizable compound.

3. The composition according to Claim 1 wherein said component (a) is selected from the group consisting of 2-ethylanthraquinone, 2,4′-diethylthioxanethone, bezil, 1-phenyl-1,2-propanedione, methylbenzoyl formate and 2,3-butanediol.

4. The composition according to Claim 1 wherein said component (b) is carbon tetrabromide or tribromomethylphenylsulfon.

5. The composition according to Claim 1 wherein said component (c) is N-methyldiethanolamine.

6. The composition according to Claim 1 further containing polymer components and polymerization inhibitors.